# EUROPÄISCHE PATENTANMELDUNG

(11) **EP 2 230 524 A1**
(43) Veröffentlichungstag der Anmeldung: **22.09.2010**
(21) Anmeldenummer: 09004081.7
(22) Anmeldetag: 21.03.2009
(51) Int. Cl.: G01R 29/20

(54) **Verfahren zur Ermittlung der Windungszahl**

(71) Anmelder: ABB Technology AG, 8050 Zürich (CH)
(72) Erfinder: Werle, Peter, Dr.-Ing., 29664 Walsrode (DE); Schreiter, Sebastian, 09496 Marienberg (DE)
(74) Vertreter: Partner, Lothar

(57) **Zusammenfassung**

Die Erfindung betrifft eine Prüfanordnung (10) zur Ermittlung der Windungszahl einer Einzelwicklung (12, 14) eines Leistungstransformators, mit einem wenigstens die Einzelwicklung (12, 14) umfassenden Prüfling (16), mit einer regelbaren Stromquelle (18) zur Einspeisung eines Prüfstromes in die Einzelwicklung (12, 14), mit einer ersten Messvorrichtung (20) zur Erfassung des Stroms durch den Wicklungsleiter der Einzelwicklung (12, 14), mit einer zweiten Messvorrichtung (22) zur Erfassung eines Summenstromes durch mehrere Windungen des Wicklungsleiter der Einzelwicklung (12, 14) und mit einer Auswertevorrichtung (24) zur Weiterverarbeitung der erfassten Messwerte (36, 38). Die zweite Messvorrichtung (22) weist wenigstens eine magnetooptische Sensorfaser auf, welche ein Erfassen eines Summenstromes ermöglicht, der durch einen von einer Sensorfaserschlaufe (26) umschlossenen Bereich fließt. Die Erfindung betrifft auch eine entsprechendes Verfahren zu Ermittlung der Windungszahl einer Einzelwicklung (12, 14) eines Leistungstransformators.

## Beschreibung

Die Erfindung betrifft eine Prüfanordnung zur Ermittlung der Windungszahl einer Einzelwicklung eines Leistungstransformators, mit einem wenigstens die Einzelwicklung umfassenden Prüfling, mit einer regelbaren Stromquelle zur Einspeisung eines Prüfstromes in die Einzelwicklung, mit einer ersten Messvorrichtung zur Erfassung des Stroms durch den Wicklungsleiter der Einzelwicklung, mit einer zweiten Messvorrichtung zur Erfassung eines Summenstromes durch mehrere Windungen des Wicklungsleiter der Einzelwicklung und mit einer Auswertevorrichtung zur Weiterverarbeitung der erfassten Messwerte.

Es ist bekannt, dass in elektrischen Energieversorgungsnetzen Leistungstransformatoren eingesetzt werden, welche Netzebenen mit verschiedenen Spannungen, beispielsweise 380kV und 110kV oder auch 110kV und 10kV, elektrisch miteinander koppeln. Das Gewicht eines Leistungstransformators beträgt einige t bis zu mehreren 100t und mehr, wobei sich die entsprechenden elektrischen Anschlussleistungen in einem Bereich von einigen MVA bis hin zu einigen 100MVA und sogar bis ca. 1000MVA bewegen.

Ein Leistungstransformator ist eine Komponente von erheblichem Wert und mit einer erheblichen Lebensdauer, beispielsweise 30 Jahre und mehr. Die Lebensdauer eines Transformators ist insbesondere durch die elektrische Isolation von dessen Wicklungen geprägt, welche einem Alterungsprozess unterworfen ist, wohingegen der Transformatorkern und der Transformatorkessel Komponenten mit deutlich höherer Lebenserwartung darstellen können.

Leistungstransformatoren sind feste Bestandteile in elektrischen Energieversorgungsnetzen. Ein Austausch eines gealterten Leistungstransformators durch einen neuen führt daher häufig zu zusätzlichem Integrationsaufwand, weil nach einer typischen Dauer von 30 Jahren kein baugleicher Transformator mehr auf dem Markt erhältlich ist.

Deshalb ist es üblich, Leistungstransformatoren nach Ablauf ihrer Lebensdauer nicht komplett zu ersetzen, sondern diese komplett zu überarbeiten, so dass die langlebigen Bestandteile wie Transformatorkern und Transformatorkessel aufgearbeitet werden und lediglich die gealterten Bestandteile, insbesondere also die Wicklungen, ausgetauscht werden. Hierzu werden die betreffenden Leistungstransformatoren aus dem Energieverteilungsnetz ausgebaut und in eine Transformatorfabrik transportiert, wo dann die Aufarbeitung durchgeführt wird.

Leistungstransformatoren sind häufig Einzelanfertigungen und deren Konstruktionsunterlagen sind zum Zeitpunkt von deren Überarbeitung, also 30 - 50 Jahre nach deren Herstellung, in den seltensten Fällen verfügbar. Somit stellt sich bei der Aufarbeitung von Leistungstransformatoren regelmäßig die Aufgabe, Ersatzwicklung für gealterte Wicklungen herzustellen, wobei deren elektrische Eigenschaften identisch sein müssen, was insbesondere die Wicklungsanzahl betrifft. In Ermanglung von Konstruktionsunterlagen wird die Wicklungsanzahl einer derartigen Leistungstransformatorwicklung seither manuell durch Abzählen oder geometrische Betrachtungen ermittelt, was zeitaufwändig und fehlerbehaftet ist. Die Ermittlung der Wicklungsanzahl ist aber auch bei neugefertigten Transformatorwicklungen von Bedeutung, welche nach ihrer Herstellung einer Qualitätsprüfung unterzogen werden.

Eine messtechnische Ermittlung der Windungsanzahl anhand eines in die Wicklung gespeisten Stromes und ein Erfassen des durch alle Windungen der Wicklung fließenden Summenstromes sowie eine darauf basierende Ermittlung des Quotienten beider Ströme, welcher dann der Wicklungsanzahl entspricht, ist theoretisch denkbar.

Die Umsetzung scheitert jedoch an der Erfassung des Summenstromes mit konventionellen Stromerfassungsgeräten, also Stromwandlern. Bei einem so großen Bauteil wie einer Transformatorwicklung ist der Aufwand, eine Messwicklung um die Gesamtheit aller Windungen der Transformatorwicklung anzuordnen, unvertretbar hoch, insbesondere weil diese Messwicklung ihrerseits eine Vielzahl von Windungen benötigt. In diese Messwicklung wird dann eine dem Stromfluss durch die von ihr umschlossenen Windungen der Transformatorwicklung entsprechende Spannung induziert.

Zudem werden die extrem hohen Genauigkeitsanforderungen, welche sich bei einer Ermittlung der Windungsanzahl einer Wicklung aus dem vergleich von Einzelstrom und Summenstrom ergeben, von einem derartigen Stromwandler nicht erfüllt. Bei 400 Windungen einer Transformatorwicklung beispielsweise würde sich bei einem Messfehler von +/- 1 %, was für einen Stromwandler eine sehr hohe Genauigkeit darstellt, eine ermittelte Windungsanzahl von 396 ... 404 ergeben. Diese Abweichung ist für den genannten Zweck zu hoch.

Ausgehend von diesem Stand der Technik ist es Aufgabe der Erfindung, eine Prüfanordnung und ein Verfahren hierzu anzugeben, mit welchen die Wicklungsanzahl einer Wicklung eines Leistungstransformators besonders einfach und genau zu ermitteln ist.

Diese Aufgabe wird gelöst durch eine Prüfanordnung der eingangs genannten Art. Diese ist **dadurch gekennzeichnet, dass** die zweite Messvorrichtung wenigstens eine magnetooptische Sensorfaser aufweist, welche ein Erfassen eines Summenstromes ermöglicht, wobei der Summenstrom durch einen von einer Sensorfaserschlaufe umschlossenen Bereich fließt. Selbstverständlich ist diese Vorrichtung auch geeignet zur Ermittlung der Windungszahl beliebiger anderer Spulen, bespielsweise Kompensationsdrosseln oder Strombegrenzungsdrosseln.

Das Messprinzip einer derartigen Messvorrichtung zur Erfassung eines Stromes beruht darauf, dass in eine magnetooptische Sensorfaser an ihrem ersten Ende ein polarisierter Lichtstrahl eingebracht wird. Eine magnetooptische Sensorfaser ist einer Glasfaser ähnlich. Die Sensorfaser umschließt in einer Schlaufe einen flächigen Bereich, durch den ein Stromfluss erfolgt. Dieser Stromfluss bewirkt eine Phasenverschiebung des sich längs der magnetooptischen Sensorfaser ausbreitenden polarisierten Lichtes. Die Phasenverschiebung, welches das polarisierte Licht längs der Sensorfaser erfährt, ist damit ein Maß für den Stromfluss.

Es ist vorgesehen, das polarisierte Licht, welches am zweiten Ende der magnetooptische Sensorfaser austritt, messtechnisch zu erfassen und die Messwerte einer Auswertung zuzuführen, so dass daraus der Stromfluss ermittelbar ist. Ebenso ist es aber denkbar, am zweiten Ende der magnetooptische Sensorfaser Reflexionsmittel vorzusehen, welche den Lichtstrahl wieder zurück in die Faser reflektieren. In diesem Fall ist am ersten Ende der magnetooptische Sensorfaser eine messtechnische Erfassung des dort austretenden Lichtstahls durchzuführen.

Beim Verwenden einer magnetooptischen Sensorfaser zum Ermitteln eines Summenstromes, welcher durch einen von einer derartigen Sensorfaser umschlossenen flächigen Bereich fließt, ergibt sich in vorteilhafter Weise bei einer sehr hohen Meßgenauigkeit ein dennoch sehr einfacher Messaufbau, weil eine einzige Sensorschlaufe genügt, wohingegen bei einem auf Induktion beruhendem Stromwandler eine Vielzahl von Windungen notwendig ist. Die mittels der magnetooptischen Sensorfaser erfasste Summenstrom ist zudem in vorteilhafter Weise unabhängig von der Geometrie des Prüfanordnung bzw. der Anordnung der Sensorfaser.

Als besonders vorteilhaft erweist sich die Variante mit einem Reflexionsmittel am zweiten Ende der Sensorfaser. In diesem Fall ist keine geschlossene Sensorfaserschleife notwendig, vielmehr ist eine mechanisch offene Sensorfaserschleife ausreichend, welche in einem Winkel von 360° bzw. auch einem ganzzahligen Vielfachen davon als Schlaufe angeordnet ist , wodurch der Messaufbau, insbesondere auch das Anbringen der Sensorfaserschleife am Prüfling, sehr vereinfacht ist.

Eine Stromquelle ist in diesem Zusammenhang als elektrische Energiequelle zu verstehen, welche sowohl in der Lage ist, einen vorgegebenen Strom einzuspeisen, so dass sich entsprechende Spannungsverteilungen ergeben, welche aber auch in der Lage ist, an ihrem Ausgang eine Spannung vorzugeben, welche dann einen entsprechenden Stromfluss zur Folge hat. Selbstverständlich sind Wechsel- und/oder Gleichgrößen vorgebbar.

Die Auswerteeinheit vergleicht den so erfassten Summenstrom mit dem durch die erste Messvorrichtung erfassten Strom durch den Wicklungsleiter. Die erste Messvorrichtung ist beispielsweise ein hochgenauer konventioneller Stromwandler beispielsweise mit Messshunt oder auch eine Stromzange bzw. Rogowskispule. Der Quotient beider Stromwerte entspricht im Wesentlichen der Windungsanzahl, welche von der Sensorschleife umschlossen sind. Die Auswertung der gemessenen Werte kann sowohl kontinuierlich erfolgen, es ist jedoch auch durchaus denkbar, zunächst alle Messwerte über den Prüfzeitraum zu erfassen, zu speichern und einer anschließenden Auswertung zuzuführen.

Weitere vorteilhafte Ausgestaltungsformen für die zweite Messvorrichtung mit magnetooptischer Sensorfaser entsprechen dem in der W02005/111633 A1 beschriebenen faseroptischen Sensorkopf, welcher eine hochpräzise Strommessungen ermöglicht.

In einer bevorzugten Ausgestaltung der erfindungsgemäßen Prüfanordnung ist die regelbare Stromquelle eine Gleichstromquelle. Die verwendete zweite Messvorrichtung ist, abweichend von einem konventionellen induktiven Stromwandler, auch in der Lage, Gleichströme zu erfassen. Durch Verwenden eines Gleichstromes als Messstrom wird die Genauigkeit der erzielten Messwerte vorteilhaft weiter gesteigert, weil alle Frequenzabhängigkeiten des Prüflings und auch der Prüfschaltung nicht zum Tragen kommen. Derartige Frequenzabhängigkeiten treten insbesondere aufgrund von Energiespeichern, also Hauptinduktivität, Streuinduktivitäten und Streukapazitäten, auf und sind damit unvermeidbar.

In einer weiteren Variante der erfindungsgemäßen Prüfanordnung sind mit der regelbaren Stromquelle beliebige zeitliche Stromverläufe vorgebbar.

Eine derartige Vorgabe besteht beispielsweise in Form einer Rampe oder einer Stufenfunktion. Auf diese Weise ist eine erhöhte Anzahl an Messwerten unter verschiedenen Randbedingungen erzeugbar, womit durch die Auswertevorrichtung beispielsweise mittels einer automatischen Selektion der Messwerte eine weiter verbesserte Aussage über die Windungsanzahl ermittelbar ist.

Entsprechend einer weiteren Ausgestaltung der erfindungsgemäßen Prüfanordnung ist die magnetooptische Sensorfaser auf einem bieg- und aufwickelbaren Schutzträger angeordnet. Hierdurch ist die Sensorfaser besonders gegen zu starke Verbiegung oder Bruch geschützt, lässt sich aber gut transportieren. Die benötigte Länge eines derartigen Schutzträgers hängt von der Größe des Prüflings ab und beträgt beispielsweise 5m bis 10m. Ein geeigneter minimaler Biegeradius beträgt beispielsweise 0,1m ... 0,5m.

Die erfindungsgemäße Aufgabe wird auch gelöst durch ein Verfahren zum Ermitteln der Windungszahl an einer Einzelwicklung eines Leistungstransformators mittels einer erfindungsgemäßen Prüfanordnung und umfasst wenigstens folgende Schritte:
- Einprägen eines Prüfstromes auf die Einzelwicklung mittels der regelbaren Stromquelle innerhalb eines Prüfzeitraumes
- gleichzeitiges Messen des Verlaufes des Stromes durch den Wicklungsleiter mittels der ersten Messvorrichtung
- gleichzeitiges Messen des Verlaufes des Summenstromes durch mehrere Windungen der Einzelwicklung mittels der zweiten Messvorrichtung
- Ermittlung der Windungsanzahl mittels der Auswertevorrichtung durch Vergleich des innerhalb des Prüfzeitraumes gemessenen Verlaufes des Stromes mit dem innerhalb des Prüfzeitraumes gemessenen Verlauf des Summenstromes

Selbstverständlich ist dieses Verfahren auch geeignet zur Ermittlung der Windungszahl beliebiger anderer Spulen, beispielsweise Kompensationsdrosseln oder Strombegrenzungsdrosseln.

Die hierdurch erzielten Vorteile entsprechen im Wesentlichen denen der zuvor beschriebenen Prüfanordnung. Der Prüfstrom, welcher während des Prüfzeitraumes durch die Prüfanordnung fließt, beträgt beispielsweise 1A bis 20A. Die Länge des Prüfzeitraumes selbst beträgt beispielsweise einige hundert Millisekunden bis mehrere Sekunden. Selbstverständlich sind beliebig viele Prüfungen, auch unter verschiedenen Randbedingungen, hintereinander durchführbar, so dass sich durch Mittelung der Einzelergebnisse ein verbessertes Endergebnis, also eine möglichst genaue Windungsanzahl, ergibt.

In einer weiteren Ausgestaltung des erfindungsgemäßen Verfahrens wird ein Gleichstrom eingeprägt, wodurch in vorteilhafter Weise die Genauigkeit weiter gesteigert wird, weil sämtliche Frequenzabhängigkeiten der Prüfanordnung ohne negative Auswirkungen auf die gemessenen Werte bleiben. Voraussetzung ist - neben einer erfindungsgemäßen zweiten Messvorrichtung, welche aufgrund ihres Funktionsprinzips auch zum Erfassen von Gleichstrom geeignet ist -, dass auch die erste Messvorrichtung zur Erfassung von Gleichstrom geeignet ist. Vorteilhaft weist daher auch die erste Messvorrichtung eine magnetooptische Sensorfaser auf und beruht nicht auf dem Induktionsprinzip. Selbstverständlich sind aber auch andere für Gleichstrom geeignete erste Messvorrichtungen verwendbar, beispielsweise ein in Reihe zur Einzelwicklung geschalteter Meßshunt wobei der durch den Stromfluß verursachte Spannungsabfall längs des Meßshunts ein Maß für diesen Stromfluß darstellt.

In einer Variante des erfindungsgemäßen Verfahrens wird durch die regelbare Stromquelle ein zeitlich vorgebbarer Stromverlauf in die Wicklung des Prüflings eingeprägt, beispielsweise in Form einer zeitlichen Rampe oder einer Stufenfunktion oder auch einer Kombination von beidem.

Im Idealfall ergibt sich zu jedem Zeitpunkt im Prüfzeitraum ein festes und der Windungsanzahl entsprechendes Verhältnis zwischen gemessenem Strom durch den Wicklungsleiter und dem gemessen Summenstrom. Aufgrund geringfügiger und unvermeidbarer Messfehler ist dennoch mit einer marginalen Ungenauigkeit der ermittelten Windungsanzahl zu rechnen. Bei Vorgabe eines zeitlich abhängigen Stromverlaufes werden unter verschiedenen Randbedingungen eine Vielzahl von Einzelergebnissen ermittelt, welche dann von der Auswerteeinheit vorteilhaft zu einem Gesamtergebnis mit erhöhter Genauigkeit zusammengefasst werden.

Durch entsprechende Testfunktionen können auch eventuelle andersartige Unregelmäßigkeiten in der Spule detektiert werden, beispielsweise Deformationen der Windungen. Eine Auswertung der Messwerte könnte dann beispielsweise mittels einer Korrelation zu Referenzmesswerten erfolgen.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:

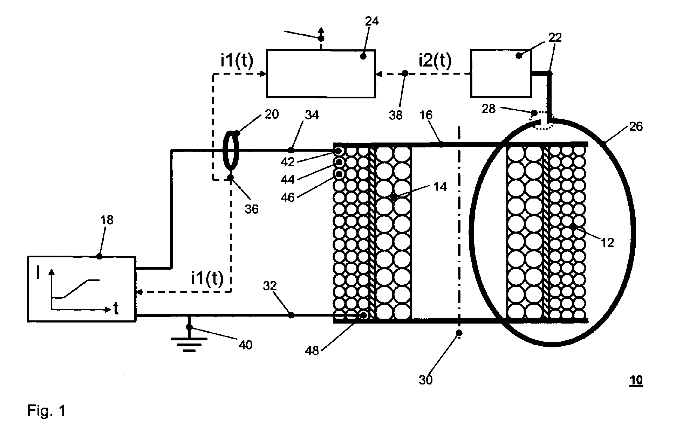

- Fig. 1: eine exemplarische Prüfanordnung
Fig. 1 zeigt ein Beispiel für eine erfindungsgemäße exemplarische Prüfanordnung 10 in einer gemischten Ansicht. In einer Schnittansicht dargestellt ist ein Prüfling 16, welcher sich rotationssymmetrisch um eine Rotationsachse 30 erstreckt. Um einen rotationsachsnahen inneren zylindrischen Hohlraum angeordnet sind eine zylindrische zweite Einzelwicklung 14, radial außen anschließend eine Isolationslage 50 sowie eine erste Einzelwicklung 12. Beide Einzelwicklungen 12, 14 sind durch eine Vielzahl von Windungen gekennzeichnet, wobei der jeweilige Wicklungsleiter lagenweise spiralförmig um die Rotationsachse 30 geführt ist. Die erste Einzelwicklung 12 ist mit ihrer ersten 42, zweiten 44, dritten 46 und n-ten 48 Windung angedeutet, wobei die erste 42 und n-te 48 Windung jeweils den Anfang bzw. das Ende bzw. des Wicklungsleiters umfasst. Beide Enden sind mit nicht gezeigten entsprechenden elektrischen Anschlüssen versehen.

Eine regelbare Stromquelle 18 ist über die Stromleitungen 32 und 34 elektrisch mit dem Anfang bzw. dem Ende des Wicklungsleiters in der ersten 42 bzw. n-ten 48 Windung verbunden, wobei die erste Stromleitung 32 an der Erdungsstelle 40 geerdet ist. Vorzugsweise sind die Stromleitungen 32, 34 als elektrisch isolierte Leitung ausgeführt und für einen Stromfluss von bis zu 20A und höher vorgesehen. Mit der regelbaren Stromquelle 18 ist ein innerhalb deren Leistungsgrenzen beliebiger Stromverlauf über die Zeit in die erste Einzelwicklung 12 einprägbar, beispielsweise in Form einer Rampe oder Stufenfunktion, aber auch einer Sinusfunktion. Durch Verwendung eines Gleichstromes einerseits werden Messungenauigkeiten in vorteilhafter Weise reduziert. Selbstverständlich sind zwischen Stromquelle 18 und zweiter Einzelwicklung bedarfsweise noch weitere elektrische Komponenten wie beispielsweise ein elektrischer Widerstand verschaltbar.

Eine erste Messvorrichtung 20, beispielsweise ein auf einem optischen Messprinzip basierender Stromwandler oder auch einem hochgenauen konventionellen Stromwandler, ist an der zweiten Stromleitung 34 angeordnet und erfasst im Prüffall kontinuierlich den Stromfluss durch diese Leitung 34. An dessen Ausgang werden kontinuierlich die gemessenen Stromwerte 36 ausgegeben. Dies kann beispielsweise sowohl ein angepasster analoger Strom oder Spannungswert sein, welcher dem zu messenden Strom direkt und phasengenau proportional ist. Die Stromwerte können aber auch in digitaler Form als Zahlenwerte vorliegen, wobei in diesem Fall in einem bestimmten Zeitintervall, beispielsweise alle 0,1ms, ein aktualisierter Wert übertragen wird.

Die ersten Messwerte 36 werden in diesem Beispiel einerseits der regelbaren Stromquelle 18 zur Verfügung gestellt, um so eine die Rückkopplung für die Reglung des Stromes zu ermöglichen. Andererseits werden die gemessenen ersten Werte auch der Auswerteeinrichtung 24 zur Verfügung gestellt. Weiterhin werden der Auswertevorrichtung 24 auch die zweiten Messwerte 38 der zweiten Messvorrichtung 22 zur Verfügung gestellt.

Die zweite Messvorrichtung 22 weist eine Sensorfaserschlaufe 26 auf, welche aus einer magnetooptischen Sensorfaser gebildet ist. Eine derartige Sensorfaser weist ähnliche Eigenschaften auf, wie eine Glasfaser, deren optisches Verhalten wird aber durch ein Magnetfeld beeinflusst, insbesondere bezüglich einer Phasenverschiebung von polarisiertem Licht. Somit eignet sich eine derartige Sensorschlaufe zur Erfassung eines Stromflusses. Die Sensorschlaufe 26 ist nicht geschlossen, sie ist vielmehr in ihrem Endbereich 28 offen, wobei dort entsprechende Reflexionsmittel vorgesehen sind, welche einen aus der magnetooptischen Sensorfaser austretenden Lichtstrahl wieder in diese zurückleitet. In einer derartigen offenen Schlaufe ist die Sensorfaser - vorzugsweise mit einem flexiblen Schutzträger verbunden - in einfacher Weise um diejenigen Windungen zu legen, bei denen der Summenstrom durch deren Gesamtheit zu bestimmen ist. Im vorliegenden Fall ist die Sensorfaser durch den inneren Hohlbereich des Prüflings längs der Rotationsachse 30 geführt und wird in einem radial außen verlaufenden Bogen zu einer Schlaufe geformt. Im Idealfall ist der im Detailbereich 28 gezeigte Spalt infinitesimal klein, so dass die Schlaufe die entsprechenden Windungen in einem Winkel von genau 360° umfasst.

Das Kerngerät der zweiten Messvorrichtung 22, in der Zeichnung mit einem Kasten angedeutet, umfasst insbesondere eine Quelle für polarisiertes Licht, welches in die Sensorfaser eingeleitet wird und eine Messvorrichtung für das im Endbereich 28 der Faser reflektierte polarisierten Licht. Darüber hinaus sind in diesem Beispiel Analysevorrichtungen vorgesehen, welche anhand der Messwerte einen Phasenverschiebung des polarisierten Lichts und darauf basierend kontinuierlich einen jeweiligen Stromwert 38 ermitteln. Dieser kontinuierlich ermittelte Stromwert 38 kann beispielsweise in Form eines dem zu messenden Strom proportionalen Messstromes ausgegeben werden, aber auch in digitaler Form, ähnlich den ersten Messwerten 36 der ersten Messvorrichtung 20.

Die Auswertevorrichtung 24 ermittelt im Prüffall anhand einer Quotientenbildung der zweiten 38 und ersten 36 Messwerte die Wicklungsanzahl der ersten Einzelwicklung 12. Die Auswertevorrichtung 24 kann sowohl ein analoge Rechenschaltung beinhalten, vorzugsweise aber einen Digitalrechner. Ein Digitalrechner ist vorteilhaft, weil mit diesem flexible Auswertalgorithmen durchführbar sind, welche eine Auswertung beispielsweise bei einem stufenförmig in die erste Einzelwicklung 12 eingeprägten Strom verbessern bzw. ermöglichen. So werden in einem derartigen Fall beispielsweise eine Vielzahl von einzelnen Teilergebnissen, bzw. Wicklungsverhältnissen ermittelt, wobei in einem anschließenden Weiterverarbeitungsschritt eine Plausibilitätsprüfung ggf. aus der Reihe fallende Werte eliminiert werden können.

Verbesserungsmöglichkeiten zur nochmaligen Erhöhung der Messgenauigkeit bestehen beispielsweise in der Bildung einer mehrfachen Windungsschleife im zweiten Stromleiter 34, so dass auch die erste Messvorrichtung 20 einen Summenstrom erfasst, welcher um die Anzahl der Windungsschleifen erhöht ist. Der relative Messfehler wird dadurch reduziert.

Für die Ermittlung der Windungsanzahl beispielsweise der zweiten Einzelwicklung 14 ist die beschriebene Anordnung in völlig analoger Weise verwendbar.

### Bezugszeichenliste

- 10: Exemplarische Prüfanordnung
- 12: erste Einzelwicklung
- 14: zweite Einzelwicklung
- 16: Prüfling
- 18: regelbare Stromquelle
- 20: erste Messvorrichtung
- 22: zweite Messvorrichtung
- 24: Auswertevorrichtung
- 26: Sensorfaserschlaufe
- 28: Endbereich der Sensorfaserschlaufe
- 30: Rotationsachse
- 32: erste Stromleitung
- 34: zweite Stromleitung
- 36: erste Messwerte
- 38: zweite Messwerte
- 40: Erdung
- 42: erste Windung
- 44: zweite Windung
- 46: dritte Windung
- 48: n-te Windung
- 50: Isolationslage

## Patentansprüche

1. Prüfanordnung (10) zur Ermittlung der Windungszahl einer Einzelwicklung (12, 14) eines Leistungstransformators, mit einem wenigstens die Einzelwicklung (12, 14) umfassenden Prüfling (16), mit einer regelbaren Stromquelle (18) zur Einspeisung eines Prüfstromes in die Einzelwicklung (12, 14), mit einer ersten Messvorrichtung (20) zur Erfassung des Stroms durch den Wicklungsleiter der Einzelwicklung (12, 14), mit einer zweiten Messvorrichtung (22) zur Erfassung eines Summenstromes durch mehrere Windungen des Wicklungsleiter der Einzelwicklung (12, 14) und mit einer Auswertevorrichtung (24) zur Weiterverarbeitung der erfassten Messwerte (36, 38), **dadurch gekennzeichnet, dass** die zweite Messvorrichtung (22) wenigstens eine magnetooptische Sensorfaser aufweist, welche ein Erfassen eines Summenstromes ermöglicht, der durch einen von einer Sensorfaserschlaufe (26) umschlossenen Bereich fließt.

2. Prüfanordnung nach Anspruch 1, **dadurch gekennzeichnet, dass** die Sensorfaserschlaufe (26) an ihrem einen Ende (28) offen ist.

3. Prüfanordnung nach Anspruch 1 oder 2, **dadurch gekennzeichnet, dass** die zweite Messvorrichtung (22) mit magnetooptischer Sensorfaser einer Ausführungsform des in der W02005/111633 A1 beschriebenen faseroptischen Sensorkopfes entspricht.

4. Prüfanordnung nach einem der vorherigen Ansprüche, **dadurch gekennzeichnet, dass** die regelbare Stromquelle (18) eine Gleichstromquelle ist.

5. Prüfanordnung nach einem der vorherigen Ansprüche, **dadurch gekennzeichnet, dass** mit der regelbaren Stromquelle (18) beliebige zeitliche Stromverläufe vorgebbar sind.

6. Prüfanordnung nach einem der vorherigen Ansprüche, **dadurch gekennzeichnet, dass** die magnetooptische Sensorfaser auf einem bieg- und aufwickelbaren Schutzträger angeordnet ist.

7. Verfahren zum Ermitteln der Windungszahl an einer Einzelwicklung eines Leistungstransformators in einer Prüfanordnung (10) entsprechend einem der Ansprüche 1 bis 6, umfassend wenigstens folgende Schritte:
• Einprägen eines Prüfstromes auf die Einzelwicklung (12, 14) mittels der regelbaren Stromquelle (18) innerhalb eines Prüfzeitraumes
• gleichzeitiges Messen des Verlaufes des Stromes durch den Wicklungsleiter mittels der ersten Messvorrichtung (20)
• gleichzeitiges Messen des Verlaufes des Summenstromes durch mehrere Windungen der Einzelwicklung mittels der zweiten Messvorrichtung (22)
• Ermittlung der Windungsanzahl mittels der Auswertevorrichtung (24) durch Vergleich des innerhalb des Prüfzeitraumes gemessenen Verlaufes des Stromes mit dem innerhalb des Prüfzeitraumes gemessenen Verlauf des Summenstromes

8. Verfahren nach Anspruch 7, **dadurch gekennzeichnet, dass** durch die regelbare Stromquelle (18) ein Gleichstrom eingeprägt wird.

9. Verfahren nach Anspruch 7 oder 8, **dadurch gekennzeichnet, dass** durch die regelbare Stromquelle (18) ein zeitlich vorgebbarer Stromverlauf eingeprägt wird.
